# EUROPEAN PATENT SPECIFICATION

(11) **EP 3 803 121 B1**
(45) Date of publication and mention of the grant of the patent: **23.10.2024**
(21) Application number: 19730442.1
(22) Date of filing: 29.05.2019
(51) Int. Cl.: F04B 37/14, F04B 53/20

(54) **FORELINE FOR A VACUUM PUMP**
EINLAUFKANAL FÜR EINE VAKUUMPUMPE
CONDUIT DE PREVIDE POUR POMPE À VIDE

(30) Priority: 31.05.2018 GB 201808954
(43) Date of publication of application: 14.04.2021
(73) Proprietor: Edwards Limited, Burgess Hill, Sussex RH15 9TW (GB)
(72) Inventor: CONDON, Neil, Burgess Hill Sussex RH15 9TW (GB); DAMS, Gregory Martin, Burgess Hill Sussex RH15 9TW (GB); MILNER, Paul, Burgess Hill Sussex RH15 9TW (GB); FIELDS, Matthew Stephen, Clevedon Somerset BS21 6TH (GB); KAROULAS, Konstantinos, Burgess Hill Sussex RH15 9TW (GB)
(74) Representative: Norton, Ian Andrew
(86) International application number: PCT/GB2019/051460
(87) International publication number: WO 2019/229428

(56) References cited:
- WO-A1-2006/087517
- US-A- 6 107 198
- US-A1- 2007 107 595
- US-A1- 2008 176 492
- US-B2- 9 664 195

## Description

The present invention relates to a foreline for a vacuum pump and a vacuum pump with such a foreline.

A foreline is a conduct or a vacuum line with an inlet and an outlet. Thereby, the inlet is connected to a vacuum vessel to be evacuated, a further conduct or any other vacuum apparatus of any kind. The outlet of the foreline is connected to an inlet of a vacuum pump, whereby a gaseous medium is conveyed by the vacuum pump from the inlet of the foreline to the outlet of the foreline, thereby establishing a vacuum at the inlet of the foreline. Since the foreline is connecting the vacuum apparatus with the inlet of the vacuum pump, a vacuum exists within the foreline.

During the semiconductor process operation dust and solid process by-product material are transferred through the process gas to the vacuum pump which will eventually result to damage of the vacuum pumping mechanism. In particular, dust and solid material might be collected on surfaces, such as the internal foreline pipe surface, within the vacuum system. Due to vibrations or excessive built-up of dust and solid material on these surfaces, a larger amount of solid material could be detached from the internal vacuum surfaces. The detached material will usually be in the form of an avalanche. Since the foreline is connected with the inlet of the vacuum pump the powder avalanche reaches the vacuum pump mechanism, wherein the effects will be catastrophic, resulting in pump seizure.

To avoid damage caused to the vacuum pump by dust and solid material, traps are employed in form of so-called dead legs, as disclosed in WO2006087517, wherein the trap is directly beneath the inlet of the foreline and the conduct of the foreline towards the vacuum pump branches off the straight connection between the inlet and the trap. Thus an angled vacuum line is established deviating from the optimal straight form. Thereby, the pump performance is decreased due to a decrease of the conductance of the foreline by including the branch.

It is also known to provide a discharge line within the foreline, as disclosed in US2008176492, such that the dust and solid material can be captured as it travels down the foreline, but this type of arrangement can cause loss of conductance.

Further, in the existing art, it is usually not possible to empty the trap during operation. Thus, the complete vacuum system must be shut down in order to access and empty the trap which results in an interruption of the semiconductor process and induces delays to the service intervals, hence extending the system downtime.

It is an object of the present invention to provide a foreline with improved pump performance which reduces the service times.

The given technical problem is solved by a foreline in accordance with claim 1 and a vacuum pump in accordance with claim 13.

In accordance to the present invention, the foreline for a vacuum pump comprises an inlet connectable e.g. to a vessel to be evacuated and an outlet connectable to an inlet of the vacuum pump to evacuate the vessel. Thereby, a gaseous medium is conveyed from the vessel's smooth inlet of the foreline along the foreline and through the outlet of the foreline into the pump to create a vacuum at the inlet of the foreline. Alternatively, the inlet can also be connectable to another vacuum conduct or in general to any vacuum apparatus of any kind. The present invention is not limited to a vessel. However, in any configuration there might be a vacuum with in the foreline lower than 10⁻²mbar preferably lower than 10⁻⁴mbar.

Further in accordance with the present invention, the foreline comprises a discharge line with a first end and a second end. The first end comprises an opening and the second end comprises a solid material trap which can also be described as dead end. The first end is arranged within the foreline between the inlet and the outlet and the opening is directed towards the inlet of the foreline such that incoming solid material, e.g. in the form of a powder avalanche, is collected by the opening of the discharge line. Solid material entering through the inlet of the foreline is captured by the opening of the discharge line. Solid material collected by the opening is being carried through the discharge line and captured in the solid material trap. The second end comprising the solid material trap is arranged outside the foreline. Thus, in accordance to the present invention, solid material is captured by the opening of the discharge line and then collected or stored in the solid material trap. Since the solid material trap is arranged outside the foreline, service times are reduced for emptying the trap.

Preferably, the inlet and the opening of the discharge line are arranged on a substantially vertical axis when mounted to a vacuum pump. The vertical axis is defined as an axis along the gravitational force. In more general terms, the inlet and the opening of the discharge line are arranged on a substantially straight line. Thus, solid material or dust is following the gravitational force and falling through the inlet into the opening of the discharge line and being captured. The inlet and the opening need not be arranged exactly on a vertical axis. In this regard "substantially" means that the present invention is still functional if inlet and opening are not arranged on an exactly vertical axis, but slightly inclined or displaced as long as dust and solid material is captured by the opening. However, it is preferred that the inlet and the outlet are arranged exactly on a vertical line. Thus, dust and solid material is reliably captured by the opening of the discharge line.

Preferably, the inlet and the outlet of the foreline are arranged on a substantially vertical axis when mounted to a vacuum pump. Thus, the foreline is straight without any branches or bends, maintaining the foreline's conductance properties. Thus, the foreline does not provide any branches or bends, which must be followed by the gaseous medium when flowing from the inlet of the foreline towards the outlet of the foreline. The flow path through the foreline is straightened compared to the conventional approach, thereby maintaining the pump performance characteristics of the vacuum pump.

Preferably, the foreline is arranged in a vertical orientation along a vertical axis when the foreline is attached or connected to a vacuum pump.

The opening has a diameter that is smaller than the diameter of the foreline. On one hand, solid material is collected by the opening of the discharge line, while the gaseous medium can pass the opening and thus can flow towards the outlet of the foreline, i.e. towards the vacuum pump. Thus on the other hand, solid material is sufficiently collected by the opening while the conductance of the foreline is still maintained.

The foreline has a first section having a first diameter and a second section having a second diameter. Thereby in particular, the inlet is connected with the first section while the second section is directly connected to the first section towards the outlet of the foreline. The first diameter of the first section is smaller than the second diameter of the second section. Thus, a buffing element is defined in the foreline in order to buffer fluctuations in the vacuum to ensure continuous operation of the vacuum pump. In particular, the foreline may comprise a third section which follows the second section and is preferably directly connected to the second section, therein the third section has a diameter approximately equal to the first diameter or at least smaller than the second diameter in order to reduce the second diameter of the second section such that the third section, including the outlet of the foreline, can be connected to a standard vacuum pump flange.

The opening of the discharge line is arranged in the second section, wherein the opening has a diameter larger than or equal to the first diameter and smaller than the second diameter. Since the opening is open towards the inlet of the foreline, solid material is collected by the opening which is disposed in operation directly beneath the inlet. Since the diameter of the opening is larger than the diameter of the first section, all solid material entering the inlet and the first section of the foreline is collected while the gaseous medium can pass the opening due to the larger diameter of the second section. Thus, efficient and reliable collection of solid material and dust is ensured by the opening of the discharge line, while the conductance of the foreline is still maintained, thereby maintaining/improving also the pump performance of the vacuum pump. In particular, due to the diameter of the opening which is larger than the diameter of the first section, almost all dust and solid material is collected.

Preferably, the part of the discharge line arranged within the foreline is at least partially perforated. Thus, the conductance is enhanced due to the perforation while still dust and solid material is captured by the discharge line.

Preferably, the opening is provided by a funnel, wherein more preferably, the funnel is perforated in order to enhance the conductance of the foreline since the gaseous medium can flow through the perforation of the funnel.

Preferably, the trap is releasably attached to the discharge line. Thus, it is possible to empty the trap easily by the simple operation of detaching the trap from the discharge line upon closing the isolation valve.

Preferably, a valve is disposed in the discharge line. Thus, when the valve is open, solid material is collected in the trap. If the valve is closed the trap can be emptied during operation without losing the vacuum within the foreline. Thus, service times are greatly reduced since the vacuum in the foreline can be maintained during service times.

Preferably, the trap comprises a gauge to detect the amount of solid material in the trap. Additionally, it is possible to detect avalanche events within the foreline and also being able to make a prediction for the next service time. Thus, by the detected amount of solid material in the trap by the gauge, it is possible on the one hand to plan the next service interval and avoid a damage to the pump due to prolonged service gaps, and, on the other hand, also avoid unnecessary services and maintenance activities.

Preferably, the trap comprises a scale mechanism to detect the amount of solid material in the trap by measuring the weight of the collected solid material within the trap.

Preferably, the trap comprises an inlet port to add substances into the trap such that the captured solid material is pre-treated before removing. In particular, for semiconductor fabrication reactive chemical substances might be captured by the trap, thus, pretreatment is necessary in order to avoid direct exposure of these hazardous materials to atmosphere. Preferably by pretreatment, the solid material is rendered inert. Thus, no further reaction, e.g. with oxygen, will occur when the trap is open for emptying.

Preferably, the trap comprises a port adapted to be connected to a vacuum cleaner. Thus, emptying of the trap is easy to facilitate and the risk of fine dust or small particles of solid material escaping into the environment is minimised.

Preferably, the inlet is defined by a first element and the outlet and discharge line are defined by a second element. Thus, the foreline comprises at least of a first element and of a second element which are separable from each other. Thereby, the first element is movable with respect to the second element, preferably along the vertical axis of the foreline. By moving the first element with respect to the second element the distance between a rim of the opening and a sidewall of the foreline is adjusted. Thus, the clearance between the discharge line and the foreline can be adapted, in particular if the opening is displaced in the second section. Thus, the foreline can be adapted to the required volume flow rate or through put of the attached vacuum pump. This can easily be done without replacing any conduits in order to adapt the diameter of the foreline or the opening. Hence, a single type of foreline can be used for several different kinds of vacuum apparatuses and in particular for several types of attached vacuum pumps.

Preferably, the first element comprises at least one, preferably two tabs and the second element provides at least one and preferably two tabs which are aligned with the tabs of the first element, wherein at least one, preferably two distance elements are disposed between the tabs to adjust the position of the first element relative to the second element. Thereby, the distance element can be a spacer or a screw. The distance element can control the distance between the first element and the second element in a variable way such that the clearance between the rim of the opening and the sidewall of the foreline can be variably adjusted.

A further aspect of the present invention is a vacuum pump with a foreline as previously described, wherein in operation the inlet of the foreline and the outlet of the foreline are arranged on a vertical axis. Therein the outlet of the foreline is connected to the inlet of the vacuum pump. As a consequence, the foreline is arranged upstream of the vacuum pump and a vacuum is created by the vacuum pump during operation. Preferably, the inlet and the opening of the discharge line are arranged on a substantially vertical axis. The vertical axis is defined as an axis along the gravitational force. Thus, solid material or dust is following the gravitational force and falling through the inlet into the opening of the discharge line and being captured. The inlet and the opening need not be arranged exactly on a vertical axis. In this regard "substantially" means that the present invention is still functional if inlet and opening are not arranged on an exactly vertical axis, but slightly inclined or displaced as long as dust and solid material is captured by the opening. However, it is preferred that the inlet and the outlet are arranged exactly on a vertical line. Thus, dust and solid material is reliably captured by the opening of the discharge line.

Preferably, the inlet and the outlet of the foreline are arranged on a substantially vertical axis when mounted to a vacuum pump. Thus, the foreline is straight without any branches or bends, maintaining the foreline's conductance properties. Thus, the foreline does not provide any branches or bends, which must be followed by the gaseous medium when flowing from the inlet of the foreline towards the outlet of the foreline. The flow path through the foreline is straightened compared to the conventional approach, thereby maintaining the pump performance characteristics of the vacuum pump.

In the following the invention is described as respect to specific embodiments with reference to the accompanied drawings.

It is shown:
- Figure 1: a schematic side view of the foreline in accordance with the present invention,
- Figure 2: a sectional view of the foreline shown in Figure 1,
- Figure 3: another embodiment in a sectional view in accordance with the present invention and
- Figure 4: another embodiment of the foreline in accordance with the present invention.

A foreline for a vacuum pump in accordance with the present invention comprises an inlet 10 adapted to be connectable to for example a vessel to be evacuated. Alternatively, the inlet 10 can be connected to another vacuum line or any vacuum apparatus of any kind. Therefore, the inlet 10 may comprise a vacuum flange to be connected to its counterpart. The foreline further comprises an outlet 12 which might also comprise a flange wherein the outlet 12 is adapted to be connected to a vacuum pump. By the vacuum pump a gaseous medium is conveyed from the inlet 10 of the foreline towards the outlet 12 of the foreline in order to establish or maintain a vacuum at the inlet 10 of the foreline.

In accordance to the present invention, the inlet 10 and the outlet 12 are arranged on a vertical axis 14. In particular, the complete foreline is straight without any bending in order to improve the conductance of the foreline enhancing the performance of the attached vacuum pump.

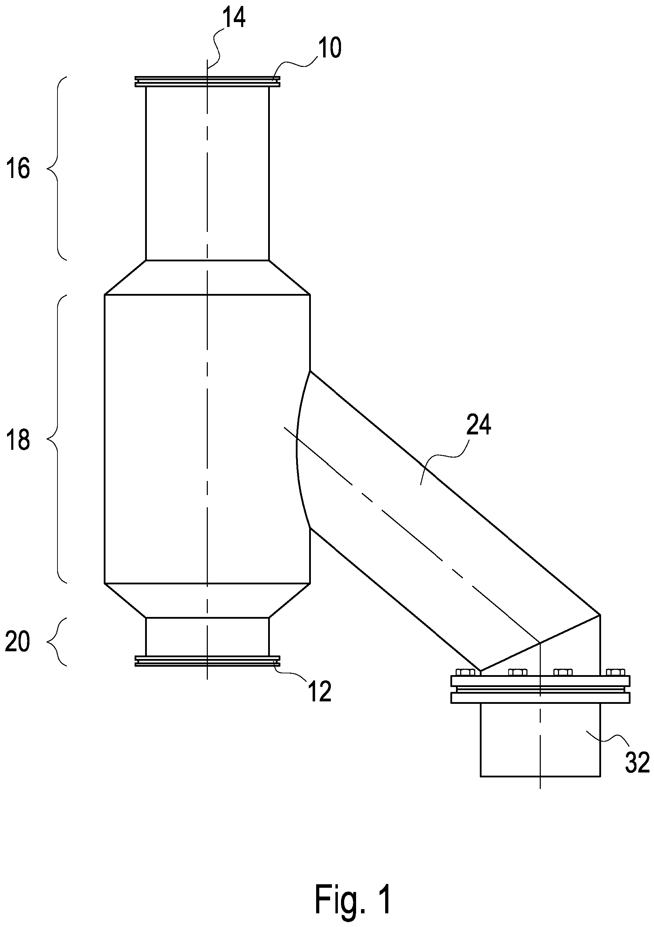

The foreline, as shown in Figure 1, comprises a first section 16 having first diameter D₁, a second section 18 having a second diameter D₂ and a third section 20 having a third diameter D₃, wherein the first diameter D₁ is identical or almost identical to the third diameter D₃, while the second diameter D₂ is larger than the first diameter D₁ and in particular also larger than the third diameter D₃. Thus, by the second section 18 a buffing element 22 is built in order to buffer fluctuations in the vacuum pressure and ensure continuous operation of the vacuum pump.

During operation, when the foreline in accordance to the present invention is attached to a vacuum pump, the vertical axis 14 corresponds to a vertical orientation, thus the inlet 10 is arranged above the outlet 12.

Further the foreline comprises a discharge line 24, having a first end 26 and a second end 28. Thereby, the first end 26 is arranged within the foreline and preferably within the second section 18. The second end 28 is arranged outside the foreline. The first end 26 comprises and opening 30 which is arranged directly beneath the inlet 10 of the foreline on a common vertical axis 14 and is open towards the inlet 10. The second end 28 of the discharge line 24 comprises a trap 32 which is releasably attached to the discharge line 24, for example by respective flanges 34. Any solid material transported by the gaseous medium or process gas which enters the foreline through the inlet 10, is collected by the opening 30 and then discharged through the discharge line 24 and finally collected in the trap 32. Thereby, the gaseous medium can pass by the opening 30 in accordance to the arrows 36 and is able to flow towards the outlet 12 of the foreline towards the vacuum pump.

As a consequence, by the straight construction of the foreline, a high conductance of the foreline is provided since the process gas needs not to follow any branches to reach the vacuum pump. Thus, the pump performance is improved. Additionally, solid material or dust entering the foreline through the inlet are collected by the opening 30 and finally collected and stored in the trap 32. Since the trap 32 is releasably attached to the discharge line 24, the trap can be easily detached and emptied during service times.

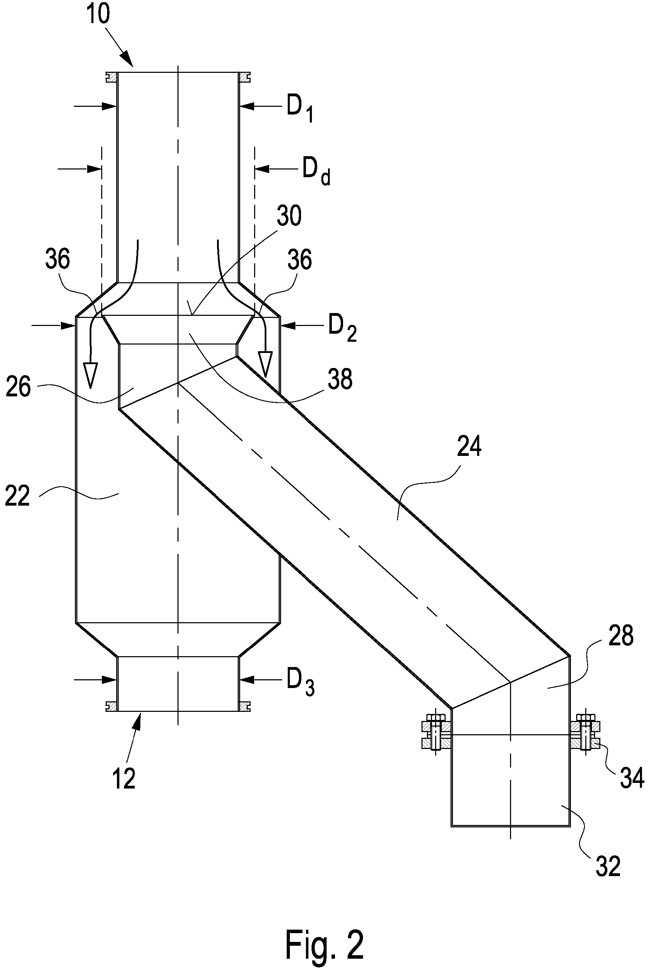

In accordance to the embodiment shown in Figure 2, the opening 30 is built by a funnel 38, wherein the funnel is preferably perforated in order to enhance the conductance of the foreline further. Thereby, the outer rim of the funnel 38 defines the opening 30, wherein the opening 30 has a diameter D_{d}. Thereby, the diameter D_{d} of the opening 30 is larger than the diameter D1 of the first section 16 and smaller than the diameter D2 of the second section 18. Thus, it is D1 < D_{d} < D2. Thereby, it is ensured that all solid material or dust is collected by the opening 30 and only the gaseous medium can pass by the opening 30 and flow towards the vacuum pump. As a consequence, no dust or solid material reaches the vacuum pump and contaminates or damage of the vacuum pump is avoided.

In the following Figures same or similar elements are indicated with identical reference numbers.

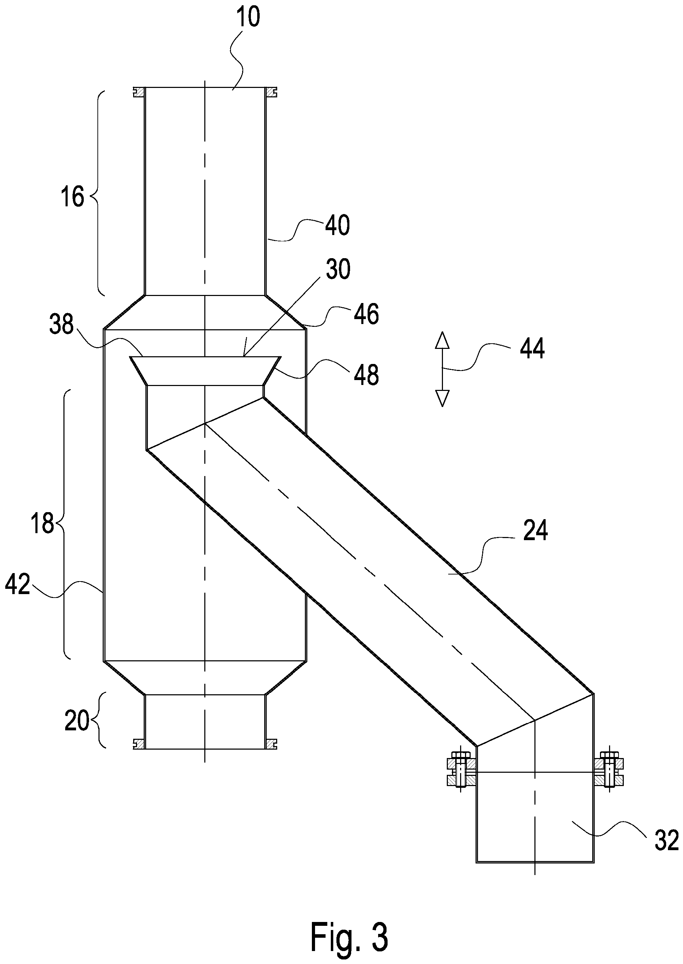

In the embodiment of Figure 3 the foreline comprises a first element 40 defining the inlet 10 and the first section 16. Further, the foreline comprises a second element 42 defining the discharge line 24 with the opening 30 and the second section 18 as well as the third section 20. Thereby, the first element 40 is relatively movable with respect to the second element 42, as indicated by the arrow 44. By adjusting the position of the first element with respect to the second element 42 along a vertical line in accordance with the arrow 44, the clearance between the sidewall 46 of the foreline and the rim 48 of the funnel 38 is adjusted. Thereby, the conductance of the foreline can be balanced with the necessity to capture more or less all solid material by the discharge line 24. If the clearance between the discharge line 24, in particular the rim 48 of the funnel 38, and the sidewall 46 is reduced, the possibility is enhanced that dust or solid material entering through the inlet 10 of the foreline is captured by the discharge line 24, i.e. the opening 30. However, simultaneously the conductance of the foreline is reduced. If the clearance between the rim 48 and the sidewall 46 is enlarged, the conductance of the foreline is improved while also increasing the possibility that dust or solid material is not collected by the opening 30 and may bypass the discharge line 24. Thus, the foreline can be adapted to the specific needs of different applications. As a consequence, only one type of foreline is necessary for a large number of different applications and also different vacuum pump types, since the clearance can also be adapted to the volume flow rate or throughput of the used vacuum pump.

In order to adjust the position of the first element 40 in relative to the position of the second element 42, the first element 40 comprises at least one tab 50 and preferably more than one tab 50. Also the second element 42 comprises an equal number of tabs 52, wherein the positions of the tabs 50 of the first element 40 are aligned with the respective positions of the tabs 52 of the second element 42. Thereby, a distance element 54 is disposed between the respective tabs 50, 52 in order to adjust and maintain the position of the first element 40 relative to the second element 42. The distance element might be a spacer or a screw, wherein at least one tab 50, 52 may comprises a thread in order to adjust the position of the first element 40 relative to the position of the second element 42 by turning the screw.

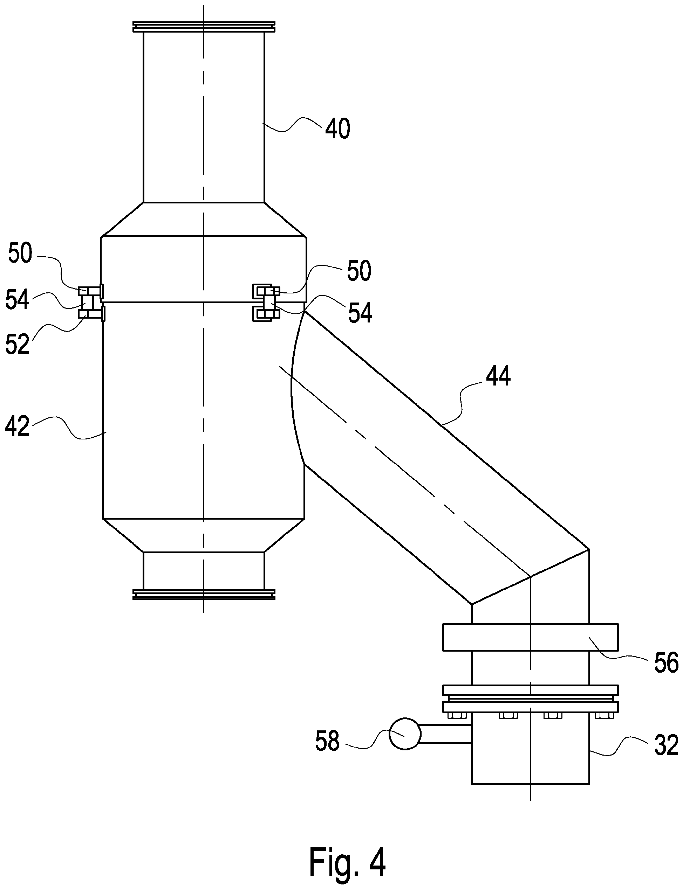

In accordance to the embodiment shown in Figure 4, the discharge line 24 comprises a gate valve 56. By closing the gate valve 56 the trap 32 can be detached from the discharge line 24 and collected dust or solid material can be removed from the trap 32 during technical service. Thus, it is possible to maintain the vacuum in the foreline during removing of the trap 32. Thus, technical service times are greatly reduced. Interruption of the operation of the vacuum system for emptying the trap 32 is not necessary due to the gate valve 56.

Further, the trap 32 provides a detection port for a gauge 58 in order to detect the amount of collected solid material or dust. Thus, the trap 32 is only emptied if necessary when the gauge detects a certain amount of collected dust or solid material.

Further the trap 32 may comprise a scale mechanism in order to rate the amount of collected dust or solid material. Thus, technical service can be planned in accordance to the collected solid material.

The present invention provides a foreline for a vacuum pump which ensures a high conductance due to the straight design of the foreline while it is ensured that almost all dust or solid material entering the foreline through the inlet is collected by the discharge line and collected or stored in the trap. Thereby, the foreline is easily maintainable due to the releasably attached trap. Further by employing a gate valve in the discharge line, maintenance can be performed during the operation of the vacuum system.

## Claims

1. A foreline for a vacuum pump with
an inlet (10) connectable to a vessel to be evacuated and
an outlet (12) connectable to an inlet of the vacuum pump to evacuate the vessel,
wherein the foreline further comprising:
a discharge line (24) with a first end (26) and a second end (28), wherein the first end comprises an opening and the second end comprises a solid material trap (32),
wherein the second end (28) is arranged outside the foreline,
wherein the first end is arranged within the foreline between inlet and outlet and the opening is open towards the inlet of the foreline such that incoming solid material is collected by the opening, discharged through the discharge line and caught in the solid material trap and **characterized in that** the foreline has a first section (16) having a first diameter and a second section (18) having a second diameter, wherein the first diameter is smaller than the second diameter, wherein **in that** the opening of the discharge line (30) is arranged in the second section, wherein the opening has a diameter larger than or equal to the first diameter and smaller than the second diameter.

2. The foreline in accordance with claim 1, **characterized in that** the inlet (10) and the opening (30) of the discharge line are arranged on a substantially vertical axis.

3. The foreline in accordance with claim 1 or 2, **characterized in that** the foreline is straight and in particular inlet (10) and outlet (12) of the foreline are arranged on a substantially vertical axis.

4. The foreline in accordance with any of claims 1 to 3, **characterized in that** the opening (30) is provided by a funnel, preferably a perforated funnel.

5. The foreline in accordance with any of claims 1 to 4, **characterized in that** the trap (32) is releasably attached to the discharge line.

6. The foreline in accordance with any of claims 1 to 5, **characterized in that** a valve (56) is disposed in the discharge line.

7. The foreline in accordance with any of claims 1 to 6, **characterized in that** the trap comprises a gauge (58) to detect the amount of solid material in the trap.

8. The foreline in accordance with any of claims 1 to 7, **characterized in that** the trap comprises a scale mechanism to detect the amount of solid material in the trap.

9. The foreline in accordance with any of claims 1 to 8, **characterized in that** the trap comprises an inlet port to add substances into the trap, such that the captured solid material is pre-treated before removing, in particular to render inert the solid material.

10. The foreline in accordance with any of claims 1 to 9, **characterized in that** the trap comprises a port adapted to be connected to a suction device preferably a vacuum cleaner.

11. The foreline in accordance with any of claims 1 to 10, **characterized in that** the inlet is defined by a first element and the outlet and discharge line is defined by a second element, wherein the first element is moveable with respect to the second element along the straight line, thus making the distance between a rim of the opening and a sidewall of the foreline-adjustable.

12. The foreline in accordance with claim 11, **characterized in that** the first element comprises at least one, preferably two tabs and the second element provides at least one, preferably two tabs which are aligned with the tabs of the first element, wherein at least one, preferably two distance elements are disposed between the tabs to adjust the position of the first element relative to the second element.

13. Vacuum pump with a foreline in accordance with any of claims 1 to 12,
wherein in operation the inlet of the foreline and the outlet of the foreline are arranged on a vertical axis.

## Patentansprüche

1. Vorleitung für eine Vakuumpumpe mit
einem Einlass (10), der an einen zu evakuierenden Behälter anschließbar ist, und
einem Auslass (12), der an einen Einlass der Vakuumpumpe anschließbar ist, um den Behälter zu evakuieren,
wobei die Vorleitung weiterhin aufweist:
eine Abflussleitung (24) mit einem ersten Ende (26) und einem zweiten Ende (28), wobei das erste Ende eine Öffnung und das zweite Ende eine Feststofffalle (32) aufweist,
wobei das zweite Ende (28) außerhalb der Vorleitung angeordnet ist,
wobei das erste Ende innerhalb der Vorleitung zwischen Einlass und Auslass angeordnet ist und die Öffnung zum Einlass der Vorleitung hin offen ist, so dass ankommende Feststoffe durch die Öffnung gesammelt, durch die Abflussleitung abgeführt und in der Feststofffalle aufgefangen werden, und **dadurch gekennzeichnet, dass** die Vorleitung einen ersten Abschnitt (16) mit einem ersten Durchmesser und einen zweiten Abschnitt (18) mit einem zweiten Durchmesser aufweist, wobei der erste Durchmesser kleiner als der zweite Durchmesser ist, wobei die Öffnung der Abflussleitung (30) in dem zweiten Abschnitt angeordnet ist, wobei die Öffnung einen Durchmesser hat, der größer als oder gleich dem ersten Durchmesser und kleiner als der zweite Durchmesser ist.

2. Vorleitung nach Anspruch 1, **dadurch gekennzeichnet, dass** der Einlass (10) und die Öffnung (30) der Ablaufleitung auf einer im Wesentlichen vertikalen Achse angeordnet sind.

3. Vorleitung nach Anspruch 1 oder 2, **dadurch gekennzeichnet, dass** die Vorleitung gerade ist und insbesondere Einlauf (10) und Auslauf (12) der Vorleitung auf einer im Wesentlichen vertikalen Achse angeordnet sind.

4. Vorleitung nach einem der Ansprüche 1 bis 3, **dadurch gekennzeichnet, dass** die Öffnung (30) durch einen Trichter, vorzugsweise einen perforierten Trichter, gebildet wird.

5. Vorleitung nach einem der Ansprüche 1 bis 4, **dadurch gekennzeichnet, dass** die Feststofffalle (32) lösbar an der Auslaufleitung befestigt ist.

6. Vorleitung nach einem der Ansprüche 1 bis 5, **dadurch gekennzeichnet, dass** in der Ablaufleitung ein Ventil (56) angeordnet ist.

7. Vorleitung nach einem der Ansprüche 1 bis 6, **dadurch gekennzeichnet, dass** die Feststofffalle ein Messgerät (58) aufweist, um die Menge an Feststoffen in der Feststofffalle zu erfassen.

8. Vorleitung nach einem der Ansprüche 1 bis 7, **dadurch gekennzeichnet, dass** die Feststofffalle einen Wiegemechanismus aufweist, um die Menge an Feststoffen in der Feststofffalle zu erfassen.

9. Vorleitung nach einem der Ansprüche 1 bis 8, **dadurch gekennzeichnet, dass** die Feststofffalle eine Einlassöffnung zur Zugabe von Substanzen in die Feststofffalle aufweist, so dass die aufgefangenen Feststoffe vor dem Entfernen vorbehandelt werden, insbesondere um die Feststoffe zu inertisieren.

10. Vorleitung nach einem der Ansprüche 1 bis 9, **dadurch gekennzeichnet, dass** die Feststofffalle einen Anschluss aufweist, der zum Anschluss an eine Saugvorrichtung, vorzugsweise einen Staubsauger, eingerichtet ist.

11. Vorleitung nach einem der Ansprüche 1 bis 10, **dadurch gekennzeichnet, dass** der Einlass durch ein erstes Element definiert ist und der Auslass und die Abflussleitung durch ein zweites Element definiert sind, wobei das erste Element in Bezug auf das zweite Element entlang der geraden Leitung bewegbar ist, wodurch der Abstand zwischen einem Rand der Öffnung und einer Seitenwand der Vorleitung einstellbar ist.

12. Vorleitung nach Anspruch 11, **dadurch gekennzeichnet, dass** das erste Element mindestens eine, vorzugsweise zwei Laschen aufweist und das zweite Element mindestens eine, vorzugsweise zwei Laschen aufweist, die mit den Laschen des ersten Elements ausgerichtet sind, wobei mindestens ein, vorzugsweise zwei Distanzelemente zwischen den Laschen angeordnet sind, um die Position des ersten Elements relativ zum zweiten Element einzustellen.

13. Vakuumpumpe mit einer Vorleitung nach einem der Ansprüche 1 bis 12, wobei im Betrieb der Einlass der Vorleitung und der Auslass der Vorleitung auf einer vertikalen Achse angeordnet sind.

## Revendications

1. Conduite de refoulement primaire pour une pompe à vide avec
une entrée (10) pouvant être reliée à un récipient à mettre sous vide et
une sortie (12) pouvant être reliée à une entrée de la pompe à vide pour mettre le récipient sous vide,
dans laquelle la conduite de refoulement primaire comprend en outre :
une conduite d'évacuation (24) avec une première extrémité (26) et une deuxième extrémité (28),
dans laquelle la première extrémité comprend une ouverture et la deuxième extrémité comprend un piège à matériau solide (32),
dans laquelle la deuxième extrémité (28) est agencée à l'extérieur de la conduite de refoulement primaire,
dans laquelle la première extrémité est agencée dans la conduite de refoulement primaire entre l'entrée et la sortie et l'ouverture est ouverte en direction de l'entrée de la conduite de refoulement primaire de telle sorte que le matériau solide entrant est collecté par l'ouverture, évacué à travers la conduite d'évacuation et attrapé dans le piège à matériau solide et **caractérisée en ce que** la conduite de refoulement primaire présente une première section (16) présentant un premier diamètre et une deuxième section (18) présentant un deuxième diamètre, dans laquelle le premier diamètre est inférieur au deuxième diamètre, dans laquelle **en ce que** l'ouverture de la conduite d'évacuation (30) est agencée dans la deuxième section, dans laquelle l'ouverture présente un diamètre supérieur ou égal au premier diamètre et inférieur au deuxième diamètre.

2. Conduite de refoulement primaire selon la revendication 1, **caractérisée en ce que** l'entrée (10) et l'ouverture (30) de la conduite d'évacuation sont agencées sur un axe sensiblement vertical.

3. Conduite de refoulement primaire selon la revendication 1 ou 2, **caractérisée en ce que** la conduite de refoulement primaire est droite et en particulier l'entrée (10) et la sortie (12) de la conduite de refoulement primaire sont agencées sur un axe sensiblement vertical.

4. Conduite de refoulement primaire selon l'une quelconque des revendications 1 à 3, **caractérisée en ce que** l'ouverture (30) est fournie par un entonnoir, de préférence un entonnoir perforé.

5. Conduite de refoulement primaire selon l'une quelconque des revendications 1 à 4, **caractérisée en ce que** le piège (32) est fixé de manière détachable à la conduite d'évacuation.

6. Conduite de refoulement primaire selon l'une quelconque des revendications 1 à 5, **caractérisée en ce qu'**une soupape (56) est disposée dans la conduite d'évacuation.

7. Conduite de refoulement primaire selon l'une quelconque des revendications 1 à 6, **caractérisée en ce que** le piège comprend une jauge (58) pour détecter la quantité de matériau solide dans le piège.

8. Conduite de refoulement primaire selon l'une quelconque des revendications 1 à 7, **caractérisée en ce que** le piège comprend un mécanisme à échelle pour détecter la quantité de matériau solide dans le piège.

9. Conduite de refoulement primaire selon l'une quelconque des revendications 1 à 8, **caractérisée en ce que** le piège comprend un orifice d'entrée pour ajouter des substances dans le piège, de telle sorte que le matériau solide capturé est prétraité avant le retrait, en particulier pour rendre le matériau solide inerte.

10. Conduite de refoulement primaire selon l'une quelconque des revendications 1 à 9, **caractérisée en ce que** le piège comprend un orifice adapté pour être relié à un dispositif d'aspiration de préférence un aspirateur.

11. Conduite de refoulement primaire selon l'une quelconque des revendications 1 à 10, **caractérisée en ce que** l'entrée est définie par un premier élément et la sortie et conduite d'évacuation est définie par un deuxième élément, dans laquelle le premier élément est mobile par rapport au deuxième élément le long de la ligne droite, rendant ainsi la distance entre un bord de l'ouverture et une paroi latérale de la conduite de refoulement primaire réglable.

12. Conduite de refoulement primaire selon la revendication 11, **caractérisée en ce que** le premier élément comprend au moins une, de préférence deux languettes et le deuxième élément fournit au moins une, de préférence deux languettes qui sont alignées avec les languettes du premier élément, dans laquelle au moins un, de préférence deux éléments de distance sont disposés entre les languettes pour régler la position du premier élément par rapport au deuxième élément.

13. Pompe à vide avec une conduite de refoulement primaire selon l'une quelconque des revendications 1 à 12,
dans laquelle lors du fonctionnement l'entrée de la conduite de refoulement primaire et la sortie de la conduite de refoulement primaire sont agencées sur un axe vertical.
